Europäisches Patentamt

European Patent Office

Office européen des brevets

(19)

(11) Publication number : **0 485 131 A1**

## (12) EUROPEAN PATENT APPLICATION

(21) Application number : **91310149.9**

(22) Date of filing : **04.11.91**

(51) Int. Cl.⁵ : **H01R 23/70, H01R 9/07**

(30) Priority : **08.11.90 US 610619**
**08.11.90 US 610871**

(43) Date of publication of application :
**13.05.92 Bulletin 92/20**

(84) Designated Contracting States :
**DE FR GB**

(71) Applicant : **AMP INCORPORATED**
**470 Friendship Road**
**Harrisburg Pennsylvania 17105 (US)**

(72) Inventor : **Goetzinger, David Joseph**
**253 Flintshire Road**
**Winston-Salem, North Carolina 27104 (US)**
Inventor : **Casciotti, Albert**
**1037 Beech Avenue**
**Hershey, Pennsylvania 17033 (US)**
Inventor : **Deak, Frederick Robert**
**285 Post Oak Road**
**Kernersville, North Carolina 27284 (US)**
Inventor : **Wrisley, David Burr, Jr.**
**1002 Rollingwood Drive**
**Greensboro, North Carolina 27410 (US)**

(74) Representative : **Warren, Keith Stanley et al**
**BARON & WARREN 18 South End Kensington**
**London W8 5BU (GB)**

(54) **High density electrical connector.**

(57) An electrical connector (10) for electrically interconnecting circuits on electrical substrates, includes a pair of tubes (28) spaced apart to receive one substrate (14) therebetween. Coil springs (32) in grooves on adjacent tube surfaces provide a normal force against circuits on a film strip (34) wrapped around the tubes (28). In one embodiment, fluid passes through the tubes to heat or cool coil springs made from a shaped memory metal alloy material.

Fig. 1

EP 0 485 131 A1

Fig. 3

The present invention relates to electrical connectors for interconnecting circuits of the type carried in printed circuit boards wherein such circuits are on close center-to-center spacings to provide high density electronic packaging.

The trend in electronic packaging with respect to the interconnection of circuits has been one of constantly increasing density, reduced center-to-center spacing, and smaller components. Thus, center line spacing has dropped from 0.100 to 0.050 inches with current trends pushing toward less than 0.010 inches for traces on printed circuit boards and contact pad centers on the order of less than 0.020 inches. With this trend, the difficulty of forming metal parts such as contact springs which provide sufficient forces of engagement of contacts to assure stable low resistance interfaces has led to difficulty in manufacture and assembly, difficulty in maintaining alignment of small parts and in mounting such parts in plastic housings. High density also leads to high cumulative contact forces which must be maintained to provide contact integrity.

U.S. Patent 4,969,824 addresses the foregoing trends by the use of a flexible printed circuit film strip which has contact pads and an assembly, including housings which have grooves along the surfaces thereof facing the printed circuit boards to contain elongated coil springs which press the film strips and their contact pads against the contact pads on the printed circuit boards to provide an interconnection.

The present invention has as one object an improvement to the foregoing patent in terms of providing a structure sufficiently rigid to assure interconnection of large numbers of contact pads to interconnect printed circuit boards and the like. It is a further object to provide a high density electrical connector utilizing a flexible film containing circuit traces on close centers in conjunction with a coil spring having a pitch on similar centers to provide a constant force along the length of the circuit strip.

With respect to high density connectors of the type being discussed, one of the problems is with respect to high density connectors where there are dozens, if not hundreds, of contact pads which can make circuit board insertion and extraction difficult with possible damage to the contacts or components carried on such boards.

Accordingly, it is another object of the present invention to provide a low force electrical connector for high density electrical interconnection applications which can be operated between two conditions, a low force engagement and a high force engagement. If is a further object to provide a low cost means effective to cause interconnections of contact pads on close centers by individual spring members in the form of a canted coil structure itself made of a shape memory alloy responsive to temperature variations to effect forces for insertion, withdrawal, and mating contact. It is yet a further object to provide a novel interconnection medium capable of providing in one piece large numbers of individual force vectors along the linear length thereof which can be varied in response to selected temperature changes.

According to the invention an electrical connector is provided which includes flexible film strips wrapped around tubes having a rigid core member extending therethrough. Coil springs in grooves on the adjacent surfaces of the tubes provide normal forces to urge circuit pads on the strips against circuit pads on the daughter card positioned between the tubes and against circuit pads on the mother board on which the connector is mounted.

Embodiments of the present invention will now be described by way of example with reference to the accompanying drawings, in which:

FIGURE 1 is a perspective view of a line of electrical connectors of the present invention mounted on a mother board with a daughter card poised for insertion into the connectors;

FIGURE 2 is a perspective, exploded view of the electrical connector;

FIGURES 3 and 4 are side, partly sectioned and perspective partly sectioned views of a sub-assembly of the connector;

FIGURES 5A and 5B are side and end views of end elements of the connector;

FIGURES 6, 7 and 8 are top, end and perspective views of another embodiment of end elements of the connector;

FIGURE 9 is a perspective showing another embodiment of the connector of the invention mounted on a mother board and preparatory to receiving a daughter board for interconnection therewith;

FIGURE 10 is an enlarged sectional view including phantom representations of spring action of the connector of the invention as shown in Figure 9; and

FIGURE 11 is a schematic view of the manifolding of a refrigerant utilized in conjunction of one embodiment of the invention.

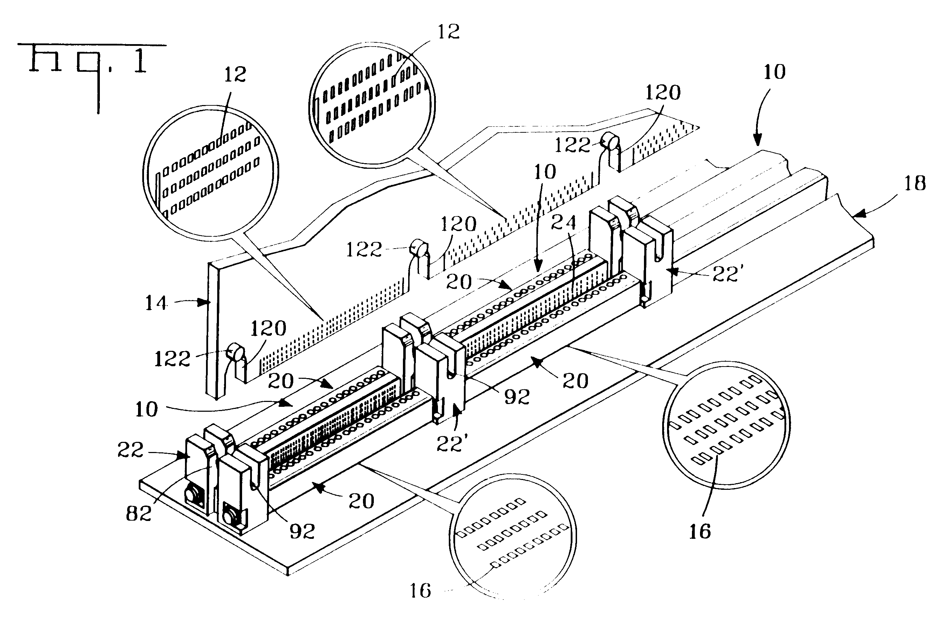

With reference to Figure 1, connector 10 of the present invention is used to electrically connect circuit pads 12 on daughter card 14 to circuit pads 16 on mother board 18. A single connector 10 includes a pair of sub-assemblies 20 and a pair of end elements 22,22' or a combination. As shown, end elements 22' are shared by adjacent connectors 10 positioned in a tandem relation. Each parallel pair of sub-assemblies 20 are spaced apart to define card slot 25 therebetween. As will be described below, elements 22 include means for aligning card 14 to provide accurate registration between pads 12 and the contact pads on sub-assemblies 20.

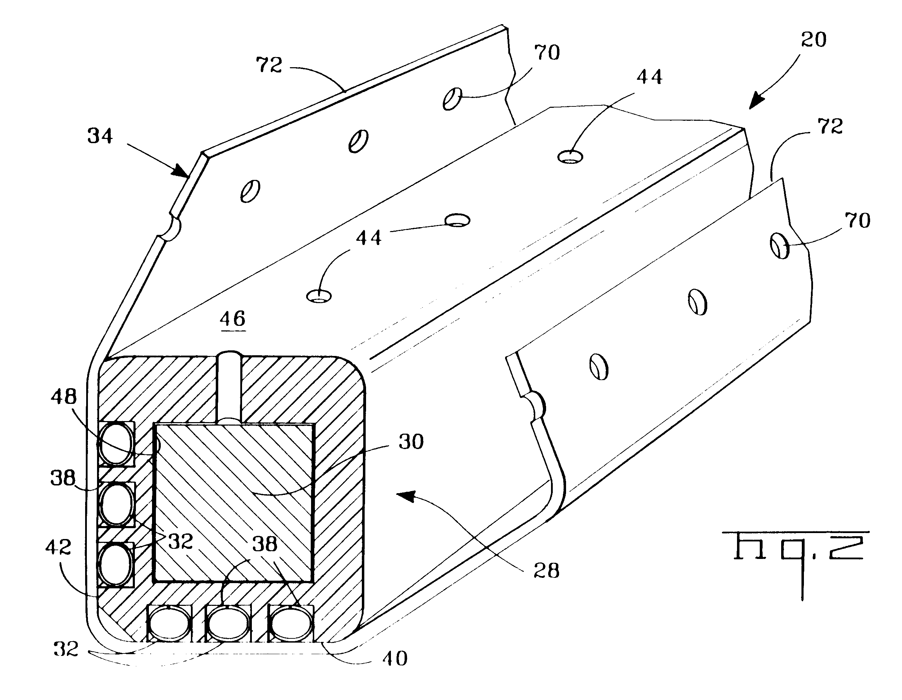

Referring now to Figure 2, a sub-assembly 20 comprises an elongated tube 28, a rigid core member 30, coiled springs 32 and a flexible, circuit carrying film strip 34.

Tube 28 may be conveniently extruded with the preferred material being aluminum or a suitable plastic such as polyether sulfone. Also the tube may be molded. These materials possess the desired properties of being thermally conductive and having a high degree of strength. Grooves 38 are provided in adjacent side surfaces 40,42 and holes 44 are provided in side surface 46. Further, a passage 48 extends longitudinally through tube 28.

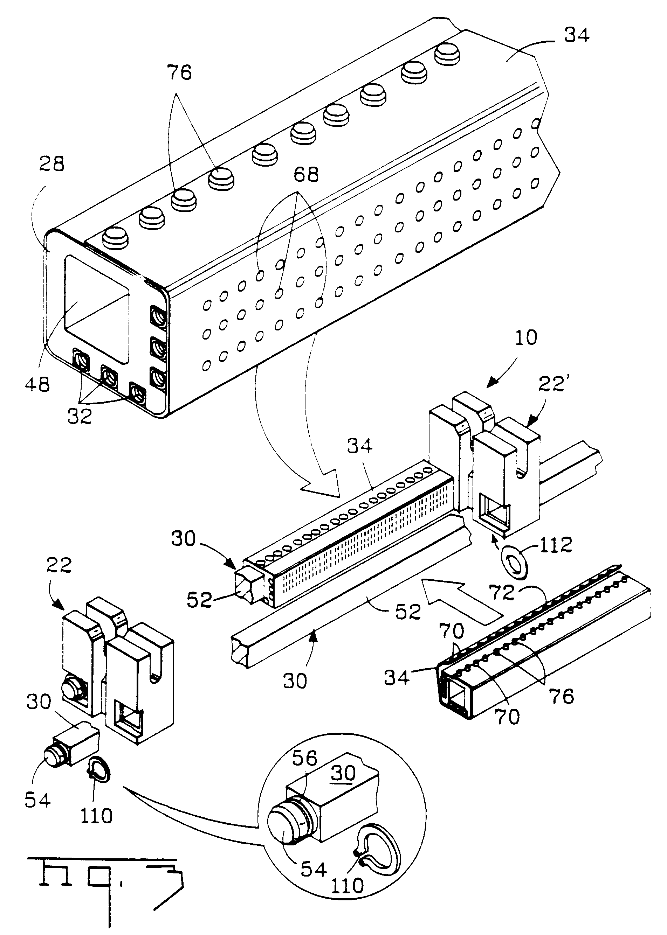

Referring also to Figure 3 now, core members 30 are formed from a suitable material such as stainless steel and include body portions 52 and at each end thereof, outwardly projecting cylindrical stubs 54. Portion 52 and passage 48 are of complementary dimensions and while shown to be rectangular in cross-section, may be of another shape; e.g., cylindrical. Stubs 54 are of a smaller cross sectional size relative to portions 52 and are provided with an annular groove 56 located adjacent the free end.

Springs 32 may be normal helical coil springs: however, the preferred springs are those in which the individual coils 60 are disposed in a preselected acute angle relative to the centerline of the spring. This advantageous arrangement causes the springs 32 to exert a constant force in a loading direction approximately normal to the centerline in response to a deflection along the loading direction. Such springs are available from the Bal Seal Engineering Company, Inc. of Santa Ana, California.

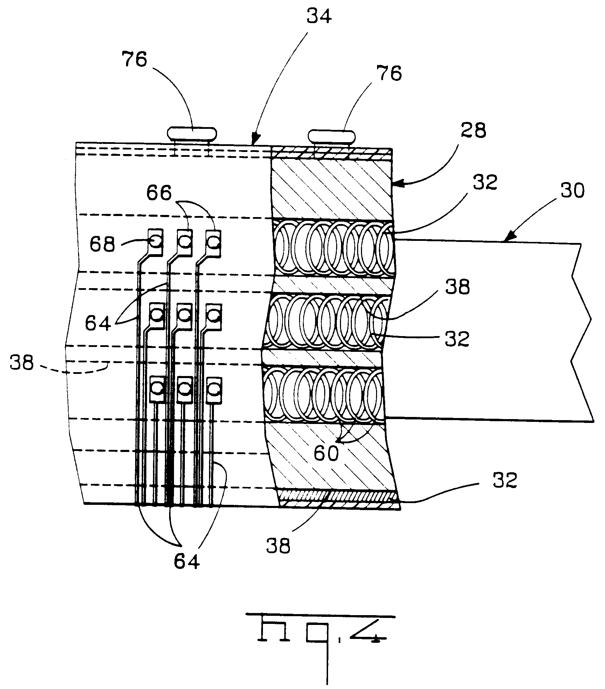

With continued reference to Figures 3 and 4, film strip 34 is of the type having conductive traces 64 deposited or otherwise fixed to a surface of an insulating material such as a polyamide film. Traces 64 terminate in circuit pads 66 preferably having a raised portion or bump 68. Bumps 68 may be plated; e.g., gold over nickel or mechanically formed. Holes 70 are provided on respective ends 72 of strip 34.

Sub-assembly 20 is assembled by positioning core members 30 in passages 48 of tube 28 with stubs 54 extending outwardly from respective ends. Springs 32 are positioned in grooves 38 and protrude outwardly therefrom. Film strip 34 is wrapped around tube 28 and springs 32 and secured by mushrooming pins 76 which have been inserted through holes 70 and into holes 44. Other methods of securing film strip 34 may be used with equal results.

Each end element 22 is formed from a single block 80 from a suitable material such as an aluminum alloy. An inverted U-shaped slot 82 cuts across the width of block 80 to provide one alignment means for card 14 and also to define a pair of identical posts 84 which are connected by neck 88. Besides connecting posts 84,86, neck 88 provides an upwardly facing surface 90. A second slot 92 cuts into and across top surface 94 of each post 84 in a direction normal to slot 82. Slots 92 provide the second alignment means for card 14.

Bores 96 extend through each post 84,86 below slots 92 and parallel to slot 82 of end elements 22,22'.

Counterbores 98 are provided at mouths 100 of each bore 96 and are open laterally as shown.

Projections 104 extend outwardly from bottom surface 106 and are provided with outwardly open threaded apertures 108.

Additional components include circlips 110 and O-rings 112.

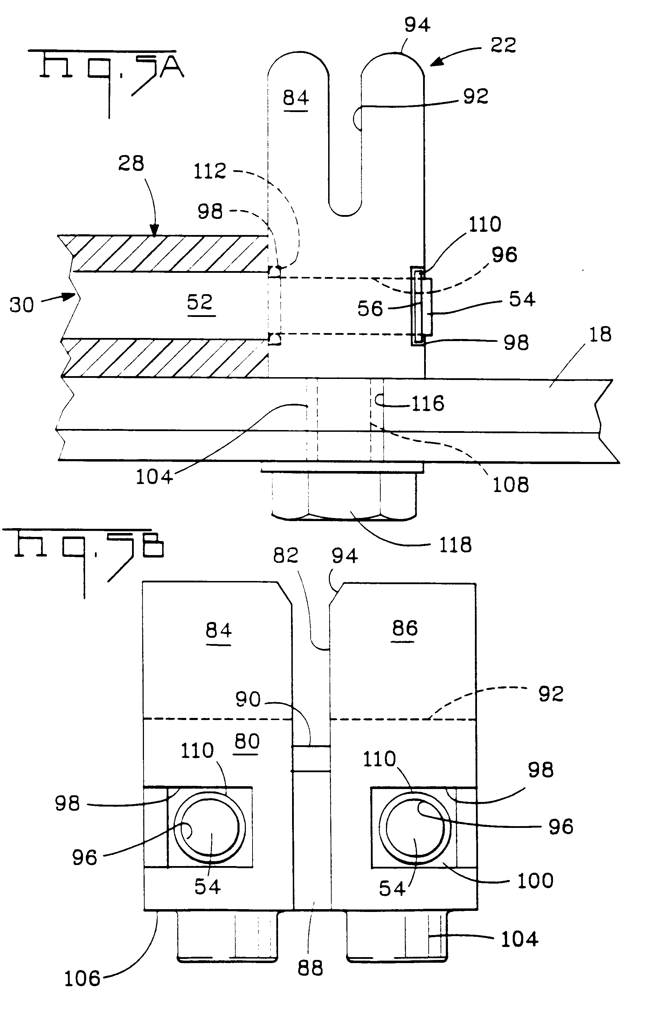

A connector 10 comprises a pair of sub-assemblies 20 with an end element at each end. Stubs 54 are received in bores 96 with an O-ring 112 positioned on the stub against body portion 52 and against the surface of counterbore 98. The free ends of stubs 54 extend into the recess area and secured with circlip 110 in groove 56 as shown in Figures 3 and 5A. The connector is then secured to a circuit board 18 by projections 104 extending through holes 116 and bolts 118 being received in threaded apertures 108.

Where a number of connectors 10 are positioned in tandem on board 18, end elements 22 are positioned between adjacent connectors 10 as shown in Figure 1. O-rings 112 are positioned in one counterbore 98 in the inward elements 22.

As shown in Figure 1, card 14 is provided with spaced cutouts 120 and laterally projecting pegs 122. The cutouts 120 are received on necks 88 defined by slots 82, resting on shoulders 90. Pegs 122 are received in slots 92. The slots 82,92, cutouts 120 and pegs 122 serve to align circuit pads 12 on card 14 with bumps 68 on traces 64.

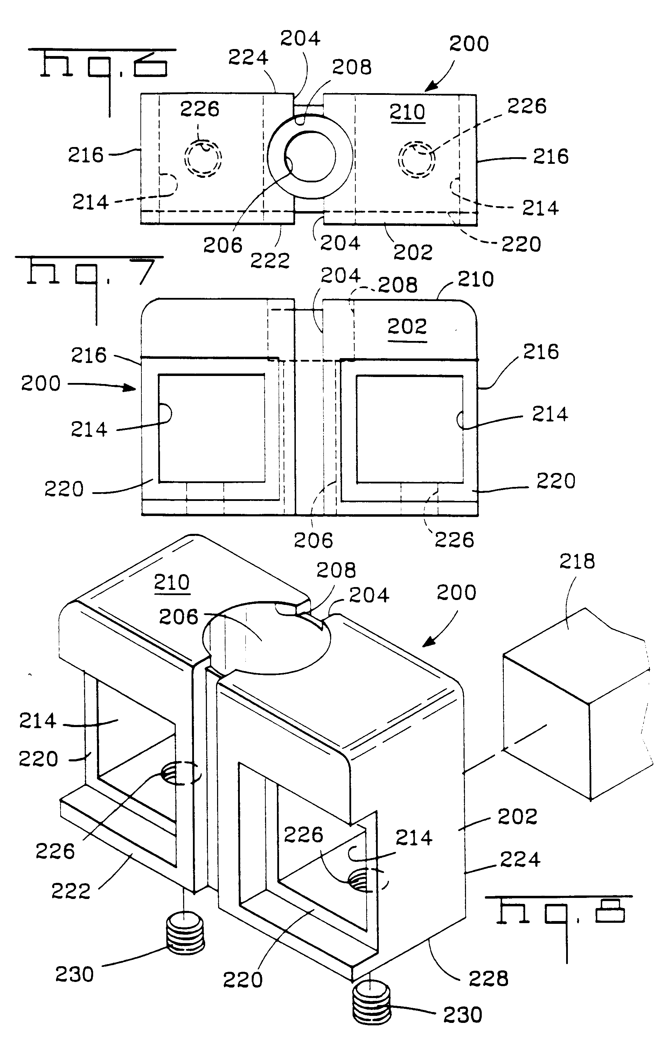

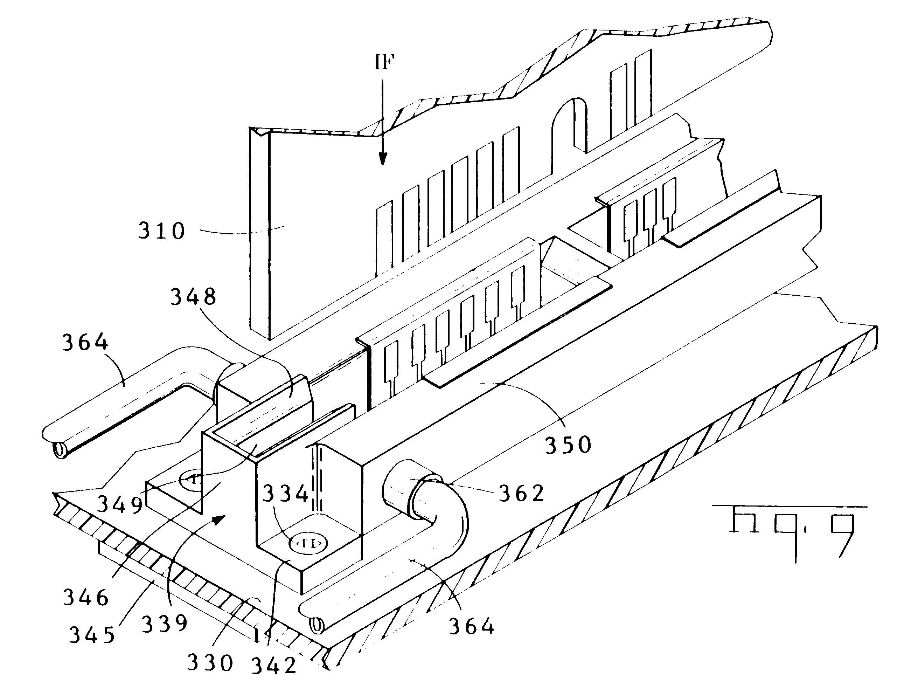

Subsequent to the development of end elements 22,22', further work resulted in the development of end elements 200 shown in Figures 6, 7 and 8. At this time, it is believed that elements 200 are preferred.

Elements 200 are formed from a block 202 of an aluminum alloy with exterior slots 204 bracketing a centrally located through hole 206. Hole 206 is provided with counter bore 208 opening onto top surface 210.

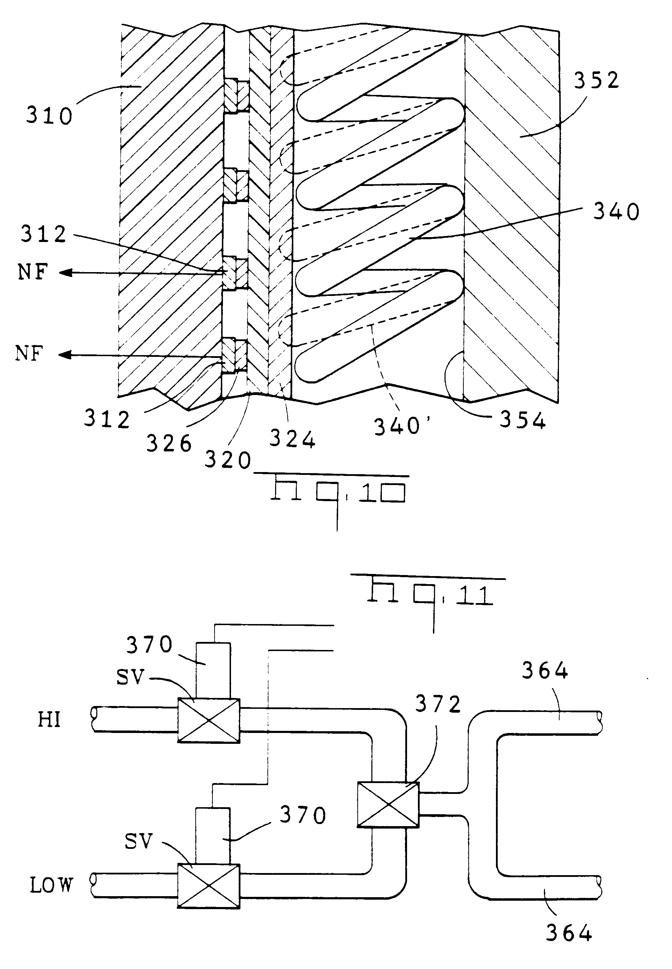

Openings 214 extend through block 202 between slots 204 and respective sides 216. Openings 214, which are dimensioned to conformably receive core member 218 shown in Figure 8, are perpendicular to hole 206 and further are provided with a counter bore 220 on end 222 on block 202 but not on opposite end 224. Threaded bores 226 extend from bottom surface 228 of block 202 into respective openings 214 and received set screws 230.

Core member 218 replaces core member 30 for use with end elements 200. As shown, member 218 is simply a shaft of a given dimension and desired shape; i.e., as will be noted below, stubs 54 and circlips 100 are not required.

In use, core members 218 are provided in the length to receive thereon all the sub-assemblies 20 and elements 200 required to provide the number of connectors 10 desired. Elements 200 are positioned on members 218 with counterbores 220 facing the same direction.

In building a series of connectors 10, the right hand ends of two core members 218 are inserted into openings 214 in an element 200 and secured therein by set screws 230. Counterbores 220 are facing down the length of members 218 and have therein O-rings 112 which protrude therefrom slightly. Two sub-assemblies 20 are slid onto respective members 218 followed by an element 200 with counterbores 220 facing away from the sub-assemblies. Sub-assemblies 20 are pressed against O-rings 112 and the second element 200 secured against the opposite ends with set screws 230 bearing against respective core members 218. Another two O-rings 112 are positioned in counterbores 220 of the second element 200 and another two sub-assemblies 20 slid onto respective members 218 followed by a third element 200, again with counterbores 220 facing away from the second element 200. These sub-assemblies are captured between the second and third elements 200 in the same manner as noted above with the first set of two sub-assemblies. This procedure continues until the required number of connectors 10 are built.

The unit of connectors 10 and elements 200 are then secured to mother board 16 (Figure 5A) or the like by bolts (not shown) passing through holes 206 (with the heads thereof in counterbores 208), through holes in the board 16 and tightened down with nuts (not shown).

With the use of elements 200, pegs 122 on daughter card 14 may be omitted.

Referring now to Figure 9, an assembly of a daughter board 310, a mother board 330 via a connector 339 is shown with the daughter board 310 preparatory to insertion with connector 339.

The connector 339 is fabricated of a suitable material such as high strength zinc alloy to include as shown in Figure 9 at the near end a pair of flanges 342 through which are passed fasteners 344 which extend through board 330 and join a metal plate element 345 beneath the board to lock the connector thereto. Connector 339 has at each end, the near end being shown, the far end being unshown, a board guide structure 346 beveled at the top as at 348 and slotted as at 349 to receive the edge of card 310 and hold such edge in position, a similar structure at the other end not shown holding the other end edge of card 310. Integral with the guide structure 346 are connector body elements 350 spaced apart and formed of metal to be rigid and nonyielding transverse to the length thereof for purposes to be described. The connector body elements 350 are in fact hollow as indicated in Figure 2 and include relatively thick wall sections 352 (Figure 10) which, on two surfaces have grooves 354.

As is indicated in Figure 9, the board 310 and its contact paths is inserted into the connector 339 to effect an interconnection and is withdrawn therefrom to effect a disconnection.

In accordance with an aspect of the invention, the coil springs 340 (Figure 10) are made of shape memory alloy material. As heretofore mentioned, such alloys can be selected from materials to provide dramatic changes in those characteristics such as Youngs Modulus or Shear Modulus and elongation over a range of transition temperatures. Alloys being commercially used include CuZnAl, CuAl and NiTi. The June 1984 issue of Mechanical Engineering includes an article entitled "Shaped Memory Metals" which details appropriate characteristics and refers to a number of sources for such metals. A further source for shape memory metals includes Memory Corporation of Norwalk, Connecticut. As related in this article and in the foregoing referred to patents and references, alloys may be chosen which exhibit a transformation characteristics at different temperatures. Below a given transformation or phasing temperature, an alloy may exhibit a weak or Martensitic condition so as to facilitate a relatively low force per unit of deflection characteristic and above such temperature the alloy may revert to a parent beta phase or the Austenitic state exhibiting an increase in modulus. Quite the reverse characteristic may be obtained with still further alloys wherein at the higher range of temperature, above the transformation temperature, the alloy is relatively weak and below the temperature it is relatively strong.

In accordance with the invention in an illustrative embodiment, it is contemplated to use a spring 340 of shape memory alloy having a transformation temperature to a weak state at or around 40 degrees Fahrenheit. Springs 340 fabricated with such an alloy material and held below 40 degrees Fahrenheit will therefore have the weak characteristic and above such transition temperature revert to the high force characteristic.

Referring now to Figure 10, the spring 340 is shown disposed within the connector body 352 resting within the groove 354 proximate the pads 326 and the pads 312 on the daughter board. Figure 10 shows the spring 340 solidly representing the weak state and in phantom as at 340′ representing the strong condition. As can be discerned, the individual coils push against the foil 324 proximate to the contact interfaces between pads 312 and 326. The normal forces resulting therefrom, NF, create and maintain a low resistance stable interface. In accordance with a further aspect of the invention, the temperature of the springs 340 is maintained by conductive heat transfer through the metallic walls of bodies 352 to the springs themselves which are in contact with such walls, the film 320 insulating electrically. Within the bodies 352 is, in an illustrative embodiment, a heating/cooling medium which can be made to vary in temperature from on the order of 35 degrees Fahrenheit or less to on the order of 75 degrees Fahrenheit or greater. The medium is, in accordance with the invention, introduced into the interiors of connector bodies 352 through a fitting as at 362 in Figure 9 and a pipe as at 364 as shown in Figure 9. Fittings and pipes at the opposite end of the connector bodies, not shown, would remove such medium. Figure 11 shows a series of pipes, including a source of high temperature medium and a source of low temperature medium, each valved by solenoid valves SV under controls 370 to be mixed at a valve 372 and transferred to the connector bodies via pipes 364. The returns for such medium are not shown. In this way, a connector 350 may be cooled (or heated as the case might be) to allow the insertion or withdrawal of board 310 with minimum normal forces, an LIF characteristic, or a ZIF connector using the retraction of the spring in its weak condition. Thereafter, upon reinsertion of a board 310 the medium may be introduced into the connector body to heat (or cool) the springs up and cause the strong, expanded condition to occur, thus generating adequate normal forces for each of the multiple contacts of the system. The average length of time generally required is a few seconds or minutes at the most. The invention contemplates the use of systems which employ gases; e.g. Freon, air, $CO_2$, liquid nitrogen, and fluid; e.g. ethylenegylcol, water, and so forth.

The invention also contemplates that heating and cooling can be achieved by other means. For example, heating can be achieved by thermal heating strips and cooling can be achieved by electronic Peltier solid state elements which are now commercially available.

The invention contemplates a use of shape memory alloy springs in conjunction with printed circuit board and film contacts and a source of heat and/or cooling with the springs being made of a shape memory alloy material. The invention also contemplates that the springs 340, utilized to establish contact forces with the mother board, may be of a standard ca2-13nted coil spring steel in that such contacts are rarely made and broken and would, in any event, be brought into engagement by the clamping of the connector 350 through the holding portions thereof into engagement with the mother board.

## Claims

1. An electrical connector (10,339) comprising a pair of parallel tubes (28,352) having grooves (38,354) in adjacent sides with coil springs (32,340) in said grooves (38,354) and a flexible, circuit-carrying film strip (34,320) covering said springs (32,340), characterized in that said tubes (28,352) include a passage (48) therethrough.

2. The electrical connector (10,339) of claim 1 characterized in that core members (30) extend through said passages (48).

3. The electrical connector (10,339) of claim 2 characterized in that the tubes (28,352) and the core members (30) differ in rigidity.

4. The electrical connector (10,339) of claim 3 characterized in that the core members (30) are more rigid than the tubes (28,352).

5. The electrical connector (339) of claim 1 characterized in that the passage (48) is sealed at each end and provided with fluid fittings (362) and pipes (364).

6. The electrical connector (339) of claim 5 characterized in that the coil springs (32,340) are made from a shaped memory alloy material reactive to the temperature of the fluid moving through the passages (48).

7. The electrical connector (10,339) of claim 1 characterized in that a thin foil of metal (324) is provided between the springs (32,340) and film strip (34,320).

Fig. 1

fig.2

EP 0 485 131 A1

Fig. 4

Fig. 5A

Fig. 5B

Fig. 6

Fig. 7

Fig. 8

Fig. 7

Fig. 10

Fig. 11

EP 0 485 131 A1

European Patent Office

**EUROPEAN SEARCH REPORT**

Application Number

EP    91 31 0149

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl.5 ) |
| X | US-A-4 934 942 (CASCIOTTI) | 1 | H01R23/70 |
| Y | * column 1, line 31 - line 40 * | 2 | H01R9/07 |
| | * column 3, line 21 - line 27; figures 3,5 * | | |
| D | & US-A-4 969 824 | | |
| | --- | | |
| P,Y | US-A-5 026 290 (DERY) | 2 | |
| | * column 2, line 3 - line 5; figure 2 * | | |
| | ----- | | |
| | | | TECHNICAL FIELDS SEARCHED (Int. Cl.5 ) |
| | | | H01R |
| The present search report has been drawn up for all claims | | | |

| Place of search | Date of completion of the search | Examiner |
|---|---|---|
| THE HAGUE | 12 FEBRUARY 1992 | KOHLER J.W. |

EPO FORM 1503 03.82 (P0401)